# EUROPEAN PATENT APPLICATION

(11) **EP 4 766 042 A1**
(43) Date of publication of application: **24.06.2026**
(21) Application number: 25210904.6
(22) Date of filing: 23.10.2025
(51) Int. Cl.: H05K 5/30, H05K 7/02, H01M 50/20, H02J 9/06

(54) **MODULAR UNINTERRUPTIBLE POWER SUPPLY**

(30) Priority: 19.12.2024 CN 202423154095 U
(71) Applicant: Vertiv Corporation, Westerville, OH 43082 (US)
(72) Inventor: WANG, Jianwei, Shenzhen, 518055 (CN)
(74) Representative: Cousens, Nico

(57) **Abstract**

Provided in the present disclosure is a modular uninterruptible power supply, including a power cabinet and a module component arranged in the power cabinet. The interior of the power cabinet is divided into an upper space and a lower space, the module component is arranged in the lower space, the lower space is divided into a power area and a bypass area, and the module component includes power modules and a bypass component. In the modular uninterruptible power supply provided by the present disclosure, with the interior of the power cabinet being divided into the upper space and the lower space and an upper outgoing wiring copper busbar being arranged in the upper space, a user is allowed to connect a cable to the upper outgoing wiring copper busbar through the top of the power cabinet, and with the module component being arranged in the lower space and the lower space being divided into a power area and a bypass area, rationality of the modular uninterruptible power supply can be effectively improved, thus improving maintainability and reliability of the whole machine.

## Description

The present application claims priority to Chinese Patent Application No. 202423154095.0, titled "MODULAR UNINTERRUPTIBLE POWER SUPPLY", filed on December 19, 2024 with the China National Intellectual Property Administration.

### TECHNICAL FIELD

The present disclosure relates to the technical field of power supply modules, and in particular to a modular uninterruptible power supply (UPS).

### BACKGROUND

High-power modular uninterruptible power supplies currently available on the market have unreasonable internal structure layouts, resulting in low utilization of the internal space. Therefore, the high-power modular uninterruptible power supply has a large internal structure and a complicated installation, which affects convenience for an operator in performing maintenance on the high-power modular uninterruptible power supply.

### SUMMARY

An objective of the present disclosure is to provide a modular uninterruptible power supply, with which the following shortcomings of the existing high-power modular uninterruptible power supply is solved. The existing high-power modular uninterruptible power supply has an unreasonable internal structure layout, resulting in low utilization of the internal space. Therefore, the high-power modular uninterruptible power supply has a large internal structure and a complicated installation, which affects convenience for an operator in performing maintenance on the high-power modular uninterruptible power supply.

The technical solutions proposed in the present disclosure for solving the technical problem are described below. A modular uninterruptible power supply is provided, including a power cabinet and a module component arranged in the power cabinet. The interior of the power cabinet is divided into an upper space and a lower space. The module component is arranged in the lower space. The lower space is divided into a power area and a bypass area. The module component includes a plurality of power modules arranged in the power area and a bypass component arranged in the bypass area.

Further, the power area is on a left side in the lower space, and the bypass area is on a right side in the lower space.

Further, the upper space is an upper incoming line space, and an upper outgoing wiring copper busbar is arranged in the upper incoming line space.

Further, the bypass component includes a plurality of bypass modules arranged in sequence from top to bottom in the bypass area and a bypass control module arranged above the bypass modules.

Further, the bypass component further includes a monitoring module arranged between the bypass control module and the upper space, and a lightning protection board arranged between the bypass control module and the bypass modules.

Further, the plurality of power modules are arranged in sequence from top to bottom in the power area on the left side in the lower space.

Further, the modular uninterruptible power supply further includes a wiring cabinet arranged on a side of the power cabinet, wherein a plurality of wiring copper busbars are arranged in sequence from top to bottom in the wiring cabinet.

Further, a plurality of upper air outlet fans are arranged on the top of the power cabinet.

Further, the modular uninterruptible power supply further includes a wiring cabinet arranged on a side of the power cabinet, wherein a plurality of wiring copper busbars are arranged in sequence from top to bottom in the wiring cabinet, and a main input switch, a bypass input switch and an output switch are arranged respectively on the wiring copper busbars.

Further, the main input switch, the bypass input switch and the output switch are arranged on the wiring copper busbars in sequence from top to bottom, and a plurality of upper air outlet fans are arranged on the top of the power cabinet.

Advantageous effects of the modular uninterruptible power supply provided by the present disclosure are described below. With the interior of the power cabinet being divided into the upper space and the lower space and the upper outgoing wiring copper busbar being arranged in the upper space, a user is allowed to connect a cable to the upper outgoing wiring copper busbar through the top of the power cabinet, and with the module component being arranged in the lower space and the lower space being divided into a power area and a bypass area, rationality of the modular uninterruptible power supply can be effectively improved, the internal space can be fully utilized, an overall size is effectively reduced, an overall installation is ensured to be convenient and simple, and maintainability and reliability of the whole machine is improved.

### BRIEF DESCRIPTION OF THE DRAWINGS

Figure 1 is a schematic structural diagram of a modular uninterruptible power supply according to a first embodiment of the present disclosure;
Figure 2 is a first schematic structural diagram of a modular uninterruptible power supply according to a second embodiment of the present disclosure;
Figure 3 is a second schematic structural diagram of a modular uninterruptible power supply according to a second embodiment of the present disclosure;
Figure 4 is a first schematic structural diagram of a modular uninterruptible power supply according to a third embodiment of the present disclosure; and
Figure 5 is a second schematic structural diagram of a modular uninterruptible power supply according to a third embodiment of the present disclosure.

Reference numerals in the drawings are listed below:
100 Uninterruptible power supply;
10 Power cabinet; 11 Upper space; 12 Power area; 13 Bypass area;
14 Upper outgoing wiring copper busbar; 15 Upper air outlet fan; 20 Power module; 30 Bypass component;
31 Bypass module; 32 Bypass control module; 33 Monitoring module; 34 Lightning protection board;
40 Wiring cabinet; 41 Wiring copper busbar; 42 Main input switch; 43 Bypass input switch;
44 Output switch.

### DETAILED DESCRIPTION

To make the objectives, technical solutions, and advantages of the present disclosure clearer, the present disclosure is described in further detail below in conjunction with the drawings and the embodiments. It should be understood that the embodiments described herein are only for explaining the present disclosure, and are not intended to limit the present disclosure.

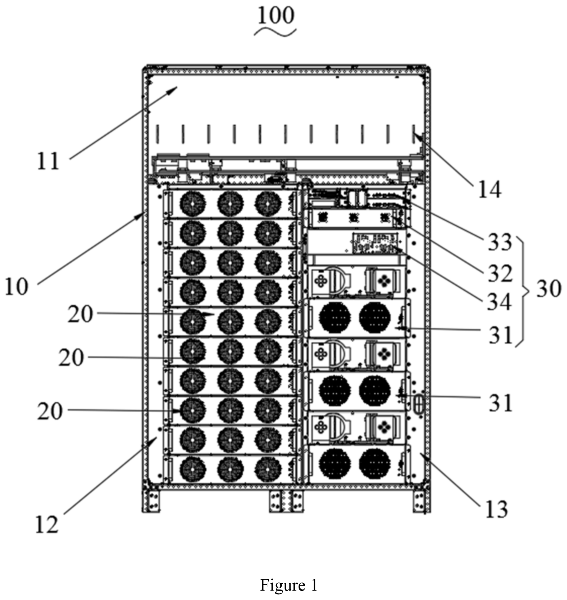

Figure 1 shows a modular uninterruptible power supply 100 according to a first embodiment of the present disclosure. A layout structure of the power modular uninterruptible power supply includes a power cabinet 10 and a module component arranged in the power cabinet 10. The interior of the power cabinet 10 is divided into an upper space 11 and a lower space. The module component is arranged in the lower space. The lower space is divided into a power area 12 and a bypass area 13. The module component includes a plurality of power modules 20 arranged in the power area 12 and a bypass component 30 arranged in the bypass area 13. In the modular uninterruptible power supply 100 provided by the present disclosure, with the interior of the power cabinet 10 being divided into the upper space 11 and the lower space and the upper outgoing wiring copper busbar 14 being arranged in the upper space 11, a user is allowed to connect a cable to the upper outgoing wiring copper busbar 14 through the top of the power cabinet 10, and with the module component being arranged in the lower space and the lower space being divided into a power area 12 and a bypass area 13, rationality of the modular uninterruptible power supply 100 can be effectively improved, the internal space can be fully utilized, an overall size is effectively reduced, an overall installation is ensured to be convenient and simple, and maintainability and reliability of the whole machine is improved.

As shown in Figure 1, in the embodiment, the power area 12 is on a left side in the lower space, the bypass area 13 is on a right side in the lower space, the upper space 11 is an upper incoming line space, and an upper outgoing wiring copper busbar 14 is arranged in the upper incoming line space. In this way, a user is allowed to realize a connection to the upper outgoing wiring copper busbar 14 through the top of the power cabinet 10, so as to meet a user demand for a product with no switch and with upper incoming line and rear air outlet. Additionally in the embodiment, a vent is opened at the rear of the power cabinet 10, and the heat generated by the power module 20 and the bypass assembly 30 is blown out of the power cabinet 10 through the vent, thereby ensuring a heat dissipation effect.

As shown in Figure 1, additionally in the embodiment, the bypass component 30 includes a plurality of bypass modules 31 arranged in sequence from top to bottom in the bypass area 13 and a bypass control module 32 arranged above the bypass modules 31. The bypass component 30 further includes a monitoring module 33 arranged between the bypass control module 32 and the upper space 11, and a lightning protection board 34 arranged between the bypass control module 32 and the bypass modules 31. With the bypass modules 31 being arranged in sequence from top to bottom in the bypass area 13 of the power cabinet 10, the monitoring module 33 being arranged between the bypass control module 32 and the upper space 11, and the lightning protection board 34 being arranged between the bypass control module 32 and the bypass module 31, the monitoring module 33, the lightning protection board 34, the bypass control module 32 and the bypass module 31 can all be arranged in sequence from top to bottom in the bypass area 13 of the power cabinet 10. In this way, the rationality of the modular uninterruptible power supply 100 is further improved, the internal space is fully used, an overall size is effectively reduced, an overall installation is ensured to be convenient and simple, and maintainability and reliability of the whole machine is improved. In addition, the bypass modules 31 are removable from the bypass area 13 of the power cabinet 10 for maintenance, so that the maintainability and reliability of the high-power modular uninterruptible power supply is further improved.

As shown in Figure 1, in the embodiment, the plurality of power modules 20 are arranged in sequence from top to bottom in the power area 12 on the left side in the lower space. With the plurality of the power modules 20 being arranged in sequence from top to bottom in the power area 12 on the left side in the lower space, utilization of the internal space of the power cabinet 10 can be effectively improved, so that the rationality of the modular uninterruptible power supply 100 is further improved, the internal space is fully used, an overall size is effectively reduced, an overall installation is ensured to be convenient and simple, and maintainability and reliability of the whole machine is improved.

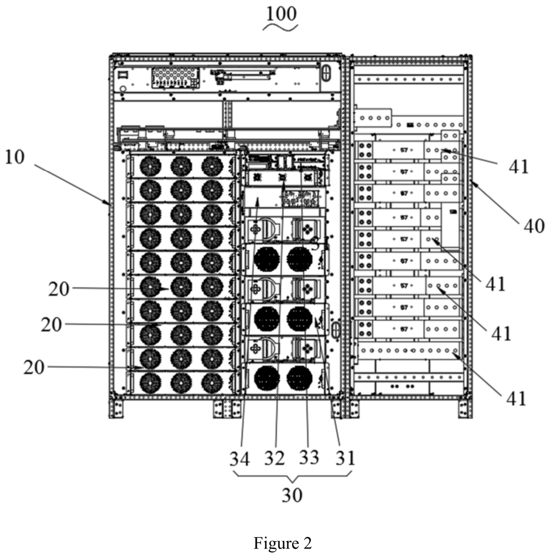

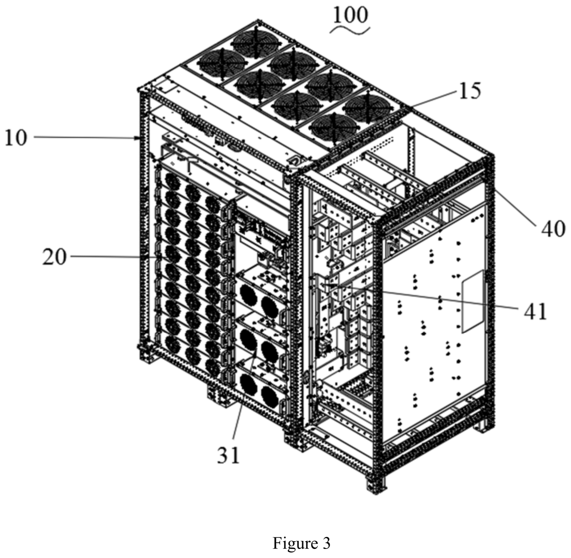

Figure 2 and Figure 3 show a modular uninterruptible power supply 100 according to a second embodiment of the present disclosure. This embodiment is different from the first embodiment in that: the modular uninterruptible power supply 100 in this embodiment further includes a wiring cabinet 40 arranged on a side of the power cabinet 10, and a plurality of wiring copper busbars 41 are arranged in sequence from top to bottom in the wiring cabinet 40. The user cable is changed from being connected to the upper outgoing wiring copper busbar 14 in the upper space 11 through the top of the power cabinet 10 to being connected to the wiring copper busbar 41 in the wiring cabinet 40, so that the user can realize connection to an upper wiring copper busbar 41 in the wiring cabinet 40 or to a lower wiring copper busbar 41 in the wiring cabinet 40, as necessary. In this way, a user demand for upper or lower incoming lines in the wiring cabinet 40 can be satisfied, while the width and depth spaces of the wiring cabinet 40 are effectively utilized for staggered arrangement of the wiring copper busbars 41, so that the rationality of the modular uninterruptible power supply 100 is improved, the internal space is fully used, an overall size is effectively reduced, an overall installation is ensured to be convenient and simple, and maintainability and reliability of the whole machine is improved.

As shown in Figure 2 and Figure 3, in the embodiment, a plurality of upper air outlet fans 15 are arranged on the top of the power cabinet 10, so that the heat dissipation effect of the power module 20 and the bypass component 30 in the power cabinet 10 is effectively ensured, and a user demand for a product with no switch and with upper/lower incoming lines and upper air outlet is satisfied. In this way, rationality of the overall layout of the power cabinet 10 is improved, and a variety of layout schemes are provided for meeting various needs of the user and being applicable to different practical scenarios.

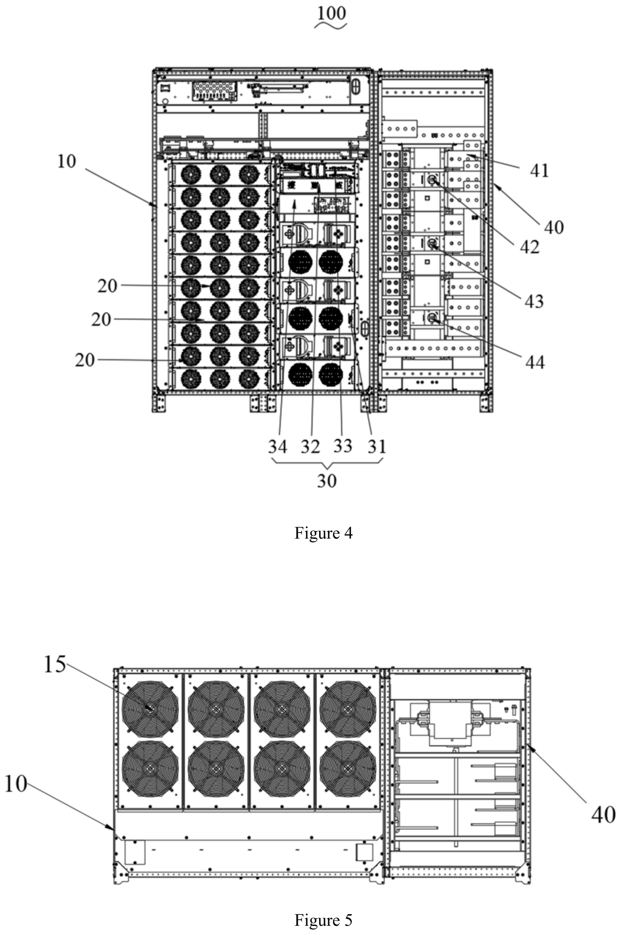

Figure 4 and Figure 5 show a modular uninterruptible power supply 100 according to a third embodiment of the present disclosure. This embodiment is different from the second embodiment in that: the modular uninterruptible power supply 100 in this embodiment has a main input switch 42, a bypass input switch 43 and an output switch 44 arranged respectively on wiring copper busbars 41 in the wiring cabinet 40. Connections to copper busbars at the middle of the wiring copper busbars 41 in the left and right portions of the wiring cabinet 40 are replaced with connections to the main input switch 42, the bypass input switch 43 and the output switch 44, so that the user can realize connection to an upper wiring copper busbar 41 in the wiring cabinet 40 or to a lower wiring copper busbar 41 in the wiring cabinet 40, as necessary. In this way, a user demand for upper or lower incoming lines in the wiring cabinet 40 can be satisfied, while the width and depth spaces of the wiring cabinet 40 are effectively utilized for staggered arrangement of the wiring copper busbars 41, so that the rationality of the modular uninterruptible power supply 100 is improved, the internal space is fully used, an overall size is effectively reduced, an overall installation is ensured to be convenient and simple, and maintainability and reliability of the whole machine is improved.

As shown in Figure 4 and Figure 5, in the embodiment, the main input switch 42, the bypass input switch 43 and the output switch 44 are arranged on the wiring copper busbar 41 in sequence from top to bottom, a plurality of upper air outlet fans 15 are arranged on the top of the power cabinet 10, so that the heat dissipation effect of the power module 20 and the bypass component 30 in the power cabinet 10 is effectively ensured, and a user demand for a product with three switches (the main input switch 42, the bypass input switch 43 and the output switch 44) and with upper/lower incoming line and upper air outlet is satisfied. In this way, rationality of the overall layout of the power cabinet 10 is improved, and a variety of layout schemes are provided for meeting various needs of the user and being applicable to different practical scenarios.

The above are only preferred embodiments of the present disclosure and are not intended to limit the present disclosure. Any modifications, substitutions and improvements made within the principles of the present disclosure should be included in the protection scope of the present disclosure.

## Claims

1. A modular uninterruptible power supply, comprising a power cabinet (10) and a module component arranged in the power cabinet (10), wherein
the interior of the power cabinet (10) is divided into an upper space (11) and a lower space, the module component is arranged in the lower space, the lower space is divided into a power area (12) and a bypass area (13), and the module component comprises a plurality of power modules (20) arranged in the power area (12) and a bypass component (30) arranged in the bypass area (13).

2. The modular uninterruptible power supply according to claim 1, wherein the power area (12) is on a left side in the lower space, and the bypass area (13) is on a right side in the lower space.

3. The modular uninterruptible power supply according to claim 1 or 2, wherein the upper space (11) is an upper incoming line space, and an upper outgoing wiring copper busbar (14) is arranged in the upper incoming line space.

4. The modular uninterruptible power supply according to claim 3, wherein the bypass component (30) comprises a plurality of bypass modules (31) arranged in sequence from top to bottom in the bypass area (13) and a bypass control module (32) arranged above the bypass modules (31).

5. The modular uninterruptible power supply according to claim 4, wherein the bypass component (30) further comprises: a monitoring module (33) arranged between the bypass control module (32) and the upper space (11), and a lightning protection board (34) arranged between the bypass control module (32) and the bypass modules (31).

6. The modular uninterruptible power supply according to claim 5, wherein the plurality of the power modules (20) are arranged in sequence from top to bottom in the power area (12).

7. The modular uninterruptible power supply according to claim 6, further comprising a wiring cabinet (40) arranged on a side of the power cabinet (10), wherein a plurality of wiring copper busbars (41) are arranged in sequence from top to bottom in the wiring cabinet (40).

8. The modular uninterruptible power supply according to claim 7, wherein a plurality of upper air outlet fans (15) are arranged on the top of the power cabinet (10).

9. The modular uninterruptible power supply according to any of claims 6 to 8, further comprising a wiring cabinet (40) arranged on a side of the power cabinet (10), wherein a plurality of wiring copper busbars (41) are arranged in sequence from top to bottom in the wiring cabinet (40), and a main input switch (42), a bypass input switch (43) and an output switch (44) are arranged respectively on the wiring copper busbars (41).

10. The modular uninterruptible power supply according to claim 9, wherein the main input switch (42), the bypass input switch (43) and the output switch (44) are arranged on the wiring copper busbars (41) in sequence from top to bottom, and a plurality of upper air outlet fans (15) are arranged on the top of the power cabinet (10).
